# EUROPÄISCHE PATENTSCHRIFT

(11) **EP 0 654 817 B1**
(45) Veröffentlichungstag und Bekanntmachung des Hinweises auf die Patenterteilung: **12.03.1997**
(21) Anmeldenummer: 94117311.4
(22) Anmeldetag: 03.11.1994
(51) Int. Cl.: H01L 21/336, H01L 21/84

(54) **Verfahren zur Herstellung einer Matrix aus Dünnschichttransistoren**
Process for fabrication of a matrix of thin film transistors
Procédé pour la fabrication d'une matrice de transistors à couche mince

(30) Priorität: 22.11.1993 DE 4339721
(43) Veröffentlichungstag der Anmeldung: 24.05.1995
(73) Patentinhaber: Lüder, Ernst, Prof. Dr.-Ing. habil., D-70550 Stuttgart (DE)
(72) Erfinder: Glück, Joachim, D-70374 Stuttgart (DE)
(74) Vertreter: Möbus, Rudolf, Dipl.-Ing.

(56) Entgegenhaltungen:
- DE-C- 4 310 640
- PATENT ABSTRACTS OF JAPAN vol. 16, no. 255 (E-1214) 10. Juni 1992 & JP-A-04 056 168
- JAPANESE JOURNAL OF APPLIED PHYSICS, Bd.32, Nr.1B, Januar 1993, TOKYO JP Seiten 469 - 473 K. KOBAYASHI ET AL
- PATENT ABSTRACTS OF JAPAN vol. 17, no. 611 (P-1641) 10. November 1993 & JP-A-05 188 396

## Beschreibung

Die Erfindung betrifft ein Verfahren zur Herstellung einer Matrix aus Dünnschichttransistoren mit Speicherkapazitäten, insbesondere für Flüssigkristallbildschirme.

Zur Herstellung einer Matrix aus a-Si:H-Dünnschichttransistoren mit Speicherkapazitäten ist aus der deutschen Patentanmeldung 43 10 640.4 bereits ein Verfahren bekannt, das mit nur drei photolithographischen Masken auskommt und mit dem Transistoren hoher Beweglichkeit erzielbar sind. In dem bekannten Herstellungsverfahren wird eine Schichtfolge bestehend aus einem Isolator, a-Si:H als undotiertem Halbleiter, einem dotierten Halbleiter sowie eine leitfähige Schicht nacheinander ohne zwischenzeitliches Strukturieren der einzelnen Schichten aufgebracht und anschließend in zwei Maskenschnitten strukturiert. Hierbei wird zunächst die leitfähige Schicht strukturiert, die anschließend als Maske für das Ätzen der dotierten und der undotierten Halbleiterschicht dient. Das Ende der Ätzprozesse der Halbleiterschichten läßt sich durch eine Kontrolle der optischen Emission des Ätzplasmas kontrollieren. Hierbei wird jedoch der dotierte Halbleiter nur im Bereich des späteren Halbleiterkanals, also auf einer Fläche, die weniger als 0,5 % der gesamten, dem Ätzplasma ausgesetzten Substratfläche beträgt, geätzt. Das optische Signal, das von dieser geringen Fläche im Ätzplasma erzeugt wird, ist in seiner Intensität so gering, daß eine Auswertung zur Überwachung des Endpunkts des Ätzprozesses dein dotierten Halbleiterschicht auf große Schwierigkeiten stößt. Dies führt zu häufigen Überätzungen, zumal die unter der dotierten Halbleiterschicht liegende intrinsische Halbleiterschicht schneller geätzt wird als die dotierte Schicht.

Der Erfindung liegt daher die Aufgabe zugrunde, ein zuverlässiges Verfahren zur Herstellung einer Matrix aus Dünnschichttransistoren mit Speicherkapazitäten, insbesondere für sigkristallbildschirme zu schaffen.

Die Aufgabe wird durch ein Verfahren der eingangs genannten Art gelöst, das erfindungsgemäß durch folgende Schritte gekennzeichnet ist:
A. Aufbringen einer ersten elektrisch leitfähigen Schicht auf ein Substrat und Strukturieren als Zeilen der Dünnschichttransistormatrix, als Gate-Kontakte der Transistoren und Grundelektroden der Speicherkapazitäten in einem ersten Maskenschritt,
B. Aufbringen eines Gate-Isolators für die Dünnschichttransistoren,
C. Aufbringen eines Halbleiters, insbesondere von a-Si:H,
D. Aufbringen eines p- oder n-dotierten Halbleiters als Drain- und Source-Kontakte der Dünnschichttransistoren,
E. Aufbringen und Strukturieren einer zweiten elektrisch leitfähigen Schicht für die Spalten der Dünnschichttransistormatrix, die Drain- und Source-Kontakte der schichttransistoren und die Gegenelektroden der Speicherkapazitäten in einem zweiten Maskenschritt,
F. Plasmaätzen der dotierten Halbleiterschicht mit der zweiten leitfähigen Schicht als Maske, wobei das Ende des Ätzprozesses durch Beobachtung der optischen Emission des Ätzplasmas festgestellt wird,
G. Strukturieren der undotierten Halbleiterschicht in einem dritten Maskenschritt,
H. Aufbringen und Strukturieren einer transparenten leitfähigen Schicht als Bildpunktelektrode und zweite Metallisierung der Spalten sowie zur leitenden Verbindung der Drain-Kontakte der Dünnschichttransistoren mit den Gegenelektroden der Speicherkapazitäten in einem vierten Maskenschritt,
I. Aufbringen einer transparenten Passivierung.

Dieses erfindungsgemäße Verfahren benötigt vier konventionelle photolithographische Maskenschritte. Im Gegensatz zum Drei-Masken-Prozeß der deutschen Patentanmeldung 43 10 640.4 wird zunächst nur die dotierte Halbleiterschicht mit der strukturierten zweiten leitfähigen Schicht als Maske geätzt. Hierbei liegt die dotierte Halbleiterschicht ganzflächig auf dem Substrat vor, da die undotierte Halbleiterschicht erst in einem nachfolgenden Schritt strukturiert wird. Durch diese große Fläche ist jetzt auch die Intensitätsänderung der optischen Plasmaemission so groß, daß eine Auswertung zur Endpunktkontrolle des Ätzprozesses problemlos möglich ist. Überätzungen können dadurch zuverlässig vermieden und die Ausbeute des Prozesses merklich erhöht werden. Dieser Vorteil gleicht die Mehrkosten für den zusätzlichen Maskenschritt gegenüber einem Drei-Masken-Prozeß mehr als aus.

Auch ein Verfahren bei dem anstelle des Aufbringens und Strukturierens einer transparenten leitfähigen Schicht als punktelektrode und anschließendes Aufbringen einer transparenten Passivierung zunächst ein transparenter Isolator in einem vierten Maskenschritt aufgebracht und strukturiert wird, wobei der Isolator an den Anschlußstellen der Matrix, dem Drain-Kontakt der Dünnschichttransistoren und an der Gegenelektrode der Speicherkapazitäten entfernt wird, und anschließend die transparente leitfähige Schicht in einem fünften Maskenprozeß aufgebracht und strukturiert wird, löst die oben angegebene Aufgabe. Bei Verwendung von Indium-Zinn-Oxid als transparente leitfähige Schicht für die Bildpunktelektrode vermeidet dieses Verfahren den bei den oben beschriebenen Drei- und Vier-Masken-Prozessen notwendigen Lift-Off-Schritt zur Strukturierung der Bildpunktelektrode und ermöglicht auch hierfür einen Ätzprozeß. Beim Drei- und Vier-Masken-Prozeß liegt das Indium-Zinn-Oxid teilweise auf der zweiten leitfähigen Schicht auf, die beispielsweise aus Aluminium bestehen kann. Sämtliche Ätzmittel für Indium-Zinn-Oxid würden auch die zweite leitfähige Schicht angreifen, so daß hier ein isoliertes Ätzen von Indium-Zinn-Oxid unmöglich ist. Beim oben beschriebenen Fünf-Masken-Prozeß wird vor Aufbringen der Indium-Zinn-Oxid-Schicht zunächst ein transparentes Oxid aufgetragen, das unempfindlich gegen die Ätzstoffe für Indium-Zinn-Oxid ist. Somit können beim Fünf-Masken-Prozeß sämtliche Strukturierungen mit Hilfe von Ätzverfahren durchgeführt werden. Zusätzliche Anlagen für die Lift-Off-Technik sind für dieses Verfahren also nicht nötig. Dieser Prozeß läßt sich somit insbesondere in bereits bestehenden Fertigungslinien mit reinen Ätzprozessen trotz des zusätzlich benötigten Maskenschrittes mit Vorteil einsetzen. Der Vorteil einer gut auswertbaren optischen Emission des Ätzplasmas beim Strukturieren der dotierten Halbleiterschicht, wobei die Intensität der Emission vorteilhafterweise bei einer Wellenlänge von 240,4 nm gemessen werden kann, bleibt bei diesem Verfahren ebenfalls erhalten. Der transparente Isolator kann im vierten Maskenschritt auch im Bereich der Bildpunktelektroden eines Flüssigkristallbildschirms entfernt werden, um die Transmission des Flüssigkristallbildschirms zu verbessern. Außerdem kann beim Fünf-Masken-Prozeß die transparente leitfähige Schicht dergestalt strukturiert werden, daß eine direkte leitfähige Verbindung zu den Drain-Kontakten der Dünnschichttransistoren, den Spalten und den Gegenelektroden der Speicherkapazitäten entsteht, was die Kontaktierung der Matrix erleichtert. Darüber hinaus kann die transparente leitfähige Schicht die Anschlußstellen der Spalten und Zeilen bedecken, wodurch eine zuverlässige elektrische Verbindung bei der Kontaktierung des Bildschirms mit zugehörigen externen Treibern gewährleistet ist, und sie kann eine zweite Metallisierung der Spalten darstellen. Die zweite Metallisierung der Spaltenleitungen stellt eine Redundanz dar und kann zur Reparatur unterbrochener Spaltenleitungen genutzt werden.

Bei beiden erfindungsgemäßen Prozessen kann die Isolation der Überkreuzungen von Zeilen- und Spaltenleitungen durch die zweite leitfähige Schicht maskiert und somit bei allen Ätzschritten geschützt sein. Damit wird eine hohe Zuverlässigkeit und Defektarmut bezüglich Kurzschlüssen an den Leitungsüberkreuzungen erreicht. Außerdem kann dadurch gemeinsam mit dem undotierten Halbleiter auch der Gate-Isolator strukturiert werden.

Als Gate-Isolator können beispielsweise SiNₓ, SiO₂, Ta₂O₅ oder Kombinationen dieser Stoffe eingesetzt werden. Für die erste Metallisierung der Spaltenleitungen und der Drain- und Source-Kontakte können Chrom, Titan, Tantal oder Chrom und Aluminium sowie verwandte Materialien aufgesputtert oder aufgedampft werden. Die Schicht für die zweite Metallisierung der Spalten läßt sich beispielsweise aufsputtern oder aufdampfen und anschließend in einem Ätz- oder Lift-Off-Verfahren strukturieren. Auch die Passivierung kann entweder in einem CVD (Chemical Vapor Deposition)- oder Sputterverfahren aufgebracht und anschließend naß- oder trockengeätzt werden. Als vorteilhafte Schichtfolge können nacheinander 400 nm SiNₓ als Gate-Isolator, 130 nm a-Si:H als Halbleiter und 50 nm n⁺-a-Si:H als Drain- und Source-Kontakte auf das Substrat mit 200 nm Chrom-Schicht für die Zeilen der Matrix, die Gate-Kontakte der Transistoren und die Grundelektroden der Speicherkapazitäten abgeschieden werden. Durch das Aufbringen des Gate-Isolators, des intrinsischen und des dotierten Halbleiters ohne eine Unterbrechung des Vakuums lassen sich Dünnschichttransistoren mit einer hohen Beweglichkeit und hoher elektrischer und thermischer Stabilität erzielen. Dabei kann die Abschaltung des Gate-Isolators, des Halbleiters und der Drain- und Source-Elektroden in einem Vakuum in einem PECVD (Plasma Enhanced Chemical Vapor Deposition)-System erfolgen.

Nachfolgend werden die erfindungsgemäßen Verfahren anhand der Zeichnung näher erläutert.

Im einzelnen zeigen:
- Fig. 1: eine Draufsicht auf einen Bildpunkt eines Flüssigkristallbildschirms mit einem Dünnschichttransistor und einer Speicherkapazität in einem ersten Herstellungsstadium des Vier-Masken-Prozesses;
- Fig. 2: einen Querschnitt durch den Bildpunkt nach Fig. 1 entlang der Linie II-II;
- Fig. 3: eine Draufsicht auf den Bildpunkt nach Fig. 1 in einem zweiten Herstellungsstadium;
- Fig. 4: einen Querschnitt durch den Bildpunkt nach Fig. 3 entlang der Linie IV-IV;
- Fig. 5: eine Draufsicht auf den Bildpunkt nach Fig. 1 in einem dritten Herstellungsstadium;
- Fig. 6: einen Querschnitt durch den Bildpunkt nach Fig. 5 entlang der Linie VI-VI;
- Fig. 7: eine Draufsicht auf den Bildpunkt nach Fig. 1 am Ende des Herstellungsverfahrens;
- Fig. 8: einen Querschnitt durch den Bildpunkt nach Fig. 7 entlang der Linie VIII-VIII;
- Fig. 9: Intensitätsverlauf einer Spektrallinie des Ätzplasmas während des Ätzens des Halbleiters;
- Fig. 10: eine Draufsicht auf einen Bildpunkt eines Flüssigkristallbildschirms mit einem Dünnschichttransistor und einer Speicherkapazität in einem ersten Herstellungsstadium des Fünf-Masken-Prozesses;
- Fig. 11: einen Querschnitt durch den Bildpunkt nach Fig. 10 entlang der Linie XI-XI;
- Fig. 12: eine Draufsicht auf den Bildpunkt nach Fig. 10 in einem zweiten Herstellungsstadium;
- Fig. 13: einen Querschnitt durch den Bildpunkt nach Fig. 12 entlang der Linie XIII-XIII;
- Fig. 14: eine Draufsicht auf den Bildpunkt nach Fig. 10 in einem dritten Herstellungsstadium;
- Fig. 15: einen Querschnitt durch den Bildpunkt nach Fig. 14 entlang der Linie XV-XV;
- Fig. 16: eine Draufsicht auf den Bildpunkt nach Fig. 10 in einem vierten Herstellungsstadium;
- Fig. 17: einen Querschnitt durch den Bildpunkt nach Fig. 16 entlang der Linie XVII-XVII;
- Fig. 18: eine Draufsicht auf den Bildpunkt nach Fig. 10 am Ende des Herstellungsverfahrens;
- Fig. 19: einen Querschnitt durch den Bildpunkt nach Fig. 18 entlang der Linie XIX-XIX.

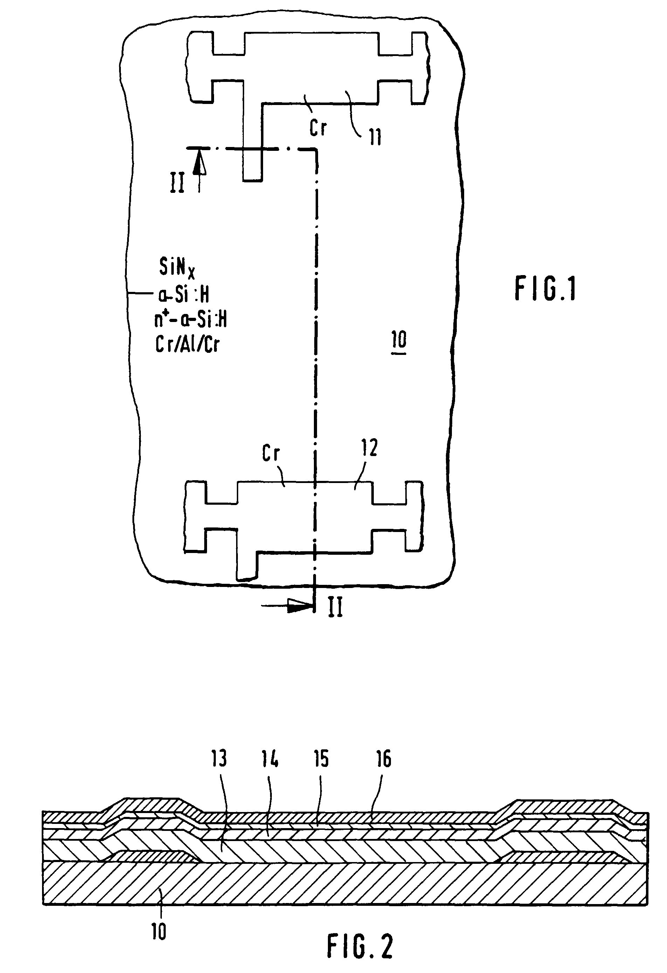

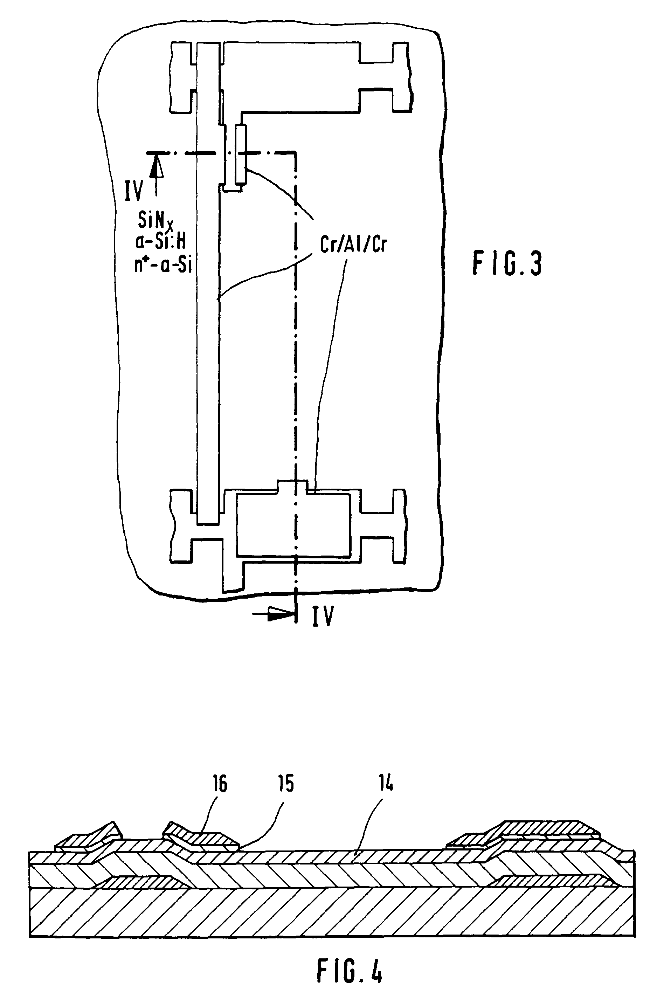

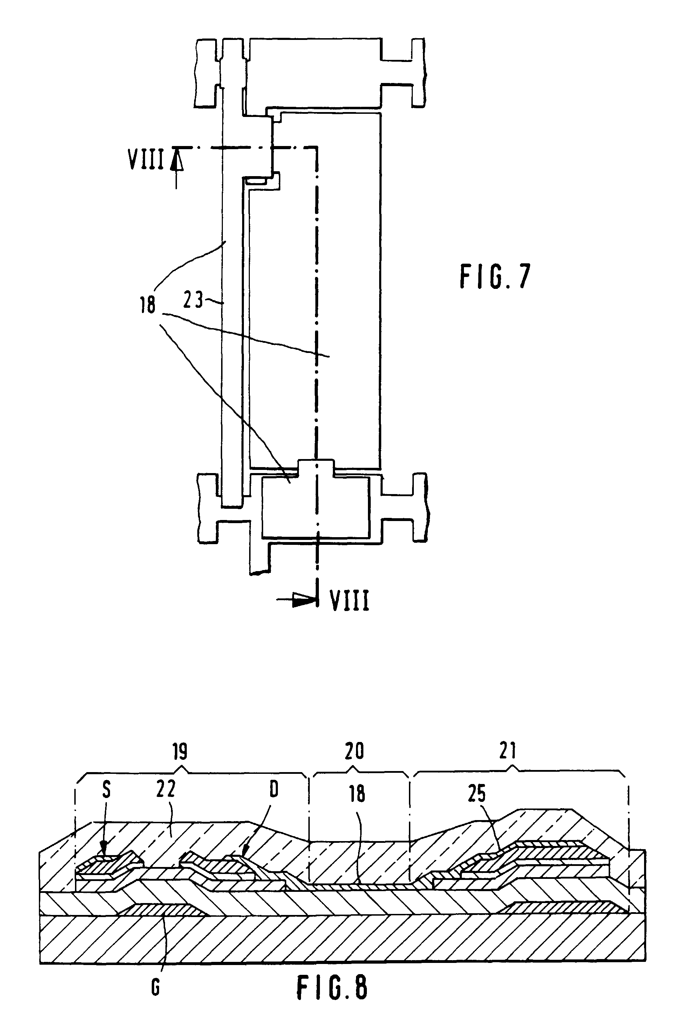

Fig. 1 zeigt zwei aufgesputterte und strukturierte Chrom-Flächen 11 und 12 auf einem Substrat 10. Die obere Fläche 11 bildet eine Zeilenleitung sowie den Gate-Kontakt G für einen Dünnschichttransistor 19 (Fig. 8) des Bildpunktes. Die untere Fläche 12 bildet die Grundelektrode einer Speicherkapazität 21 (Fig. 8). Anstelle von Chrom könnte auch Al, Mo, Ta oder Kombinationen dieser Stoffe verwendet werden. Zur Strukturierung der Chrom-Flächen 11 und 12 wird auf konventionelle Photolithographie sowie Ätztechnik zurückgegriffen. Anschließend wird das Substrat 10, wie auch aus dem Schnittbild in Fig. 2 er-sichtlich ist, unter Zuhilfenahme eines PECVD-Verfahrens (PECVD = Plasma Enhanced Chemical Vapor Deposition = Plasma unterstütztes chemisches Abscheiden aus der Gasphase) mit einer Dreifachschicht bestehend aus Siliziumnitrid 13 als Gate-Isolator, undotiertem amorphen Silizium 14 als Halbleiter und phosphordotiertem amorphem oder mikrokristallinen Silizium 15 als Drain/Source-Kontaktierung versehen. Auf diese Dreifachschicht 13 bis 15 erfolgt ein Aufsputtern oder Aufdampfen eines leitfähigen Materials, hier von Cr/Al/Cr 16. Anschließend wird die zweite leitfähige Schicht 16 in einem zweiten Maskenschritt strukturiert (Fig. 3 und 4). Auch hierzu wird konventionelle Photolithographie sowie Ätztechnik eingesetzt.

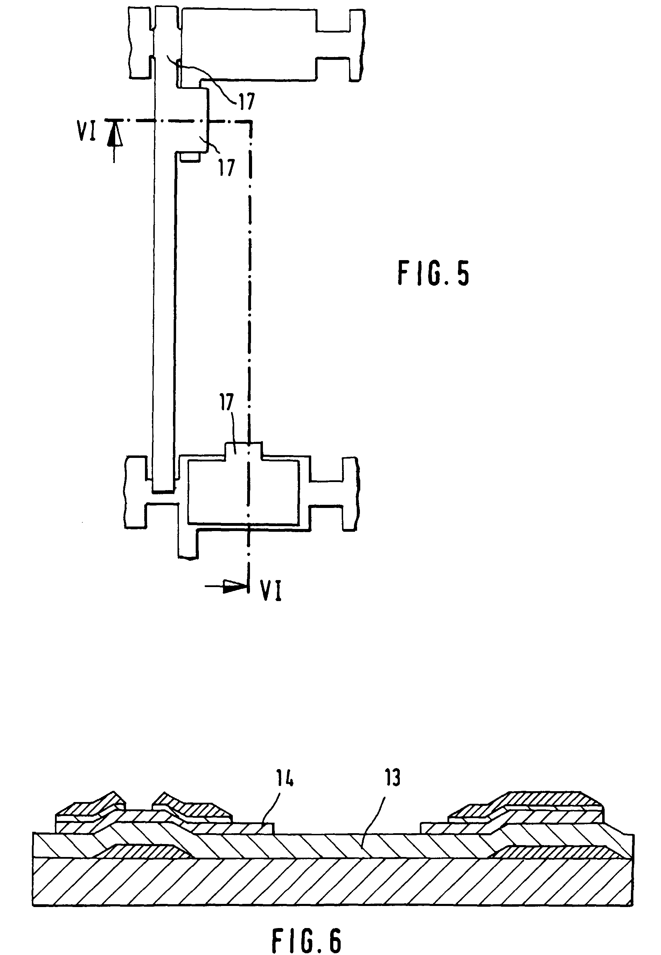

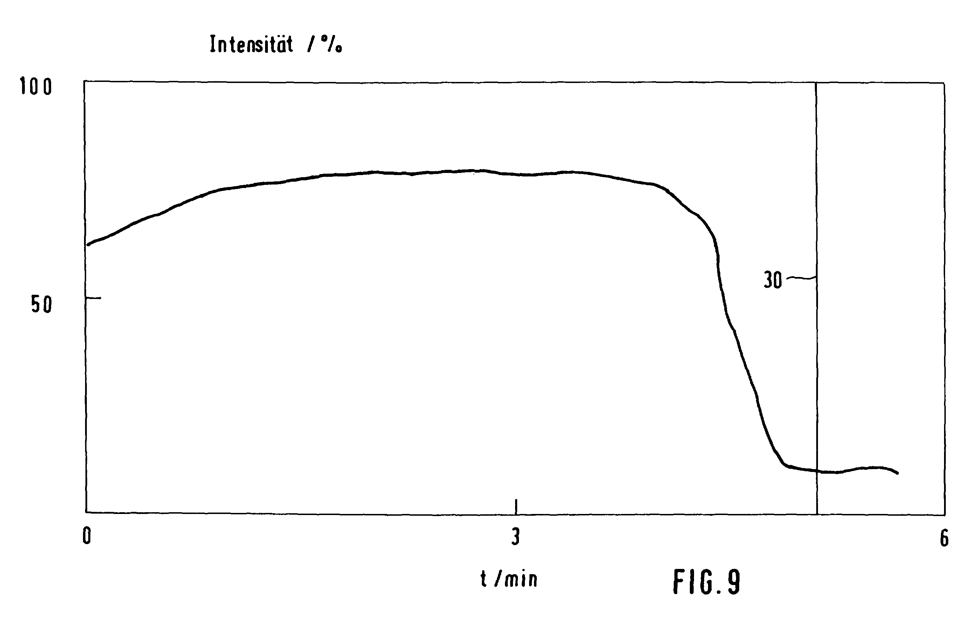

Diese zweite leitfähige Schicht stellt die Spaltenzuleitungen 23, die Drain- und Source-Metallisierung sowie die Deckelektrode des Speicherkondensators 21 dar (Fig. 7 und 8). Anschließend findet eine Trockenätzung der phosphordotierten amorphen oder mikrokristallinen Siliziumschicht 15 mittels eines Plasmaätzverfahrens statt. Als Ätzmaske dient hier die Struktur der zweiten leitfähigen Schicht 16, wie insbesondere aus Fig. 4 ersichtlich ist. Da während des Plasmaätzens keine Selektivität zwischen dotiertem und undotiertem Silizium vorhanden ist, der Ätzprozeß also nicht vor der Schicht 14 aus undotiertem Silizium von selbst stoppt, gleichzeitig aber das undotierte Silizium 14 nicht weggeätzt werden darf, muß der Ätzprozeß mit einem Endpunktkontrollgerät überwacht werden. Das Endpunktkontrollgerät detektiert die optische Emission des Ätzplasmas. Zur Prozeßüberwachung wird die zeitliche Änderung der in Fig. 9 dargestellten Intensität der optischen Emission des Ätzplasmas bei 240,4 nm gemessen. Diese Intensität ändert sich signifikant nach Abschluß der Ätzung des dotierten Siliziums, wie in Fig. 9 deutlich an dem Einbruch bei der Linie 30 zu sehen ist. Dieser Einbruch markiert also zuverlässig das Ende des Ätzvorgangs der dotierten Halbleiterschicht. Wie in den Figuren 5 und 6 dargestellt ist, wird anschließend die undotierte amorphe Siliziumschicht 14 mit einem photolithographischen Verfahren und Plasmaätztechnik in einem dritten Maskenschritt strukturiert. In Fig. 5 sind die Stellen 17, an denen die Halbleiterschicht 14 erhalten bleibt, eingezeichnet. Dieser Schritt dient dazu, die Dünnschichttransistoren der einzelnen Bildpunktelemente voneinander zu isolieren. In den Figuren 7 und 8 ist der Bildpunkt nach Aufsputtern oder Aufdampfen eines transparenten, leitfähigen Oxids wie Indium-Zinn-Oxid 18 und Strukturieren nach konventionellen thographischen Methoden und einem Lift-Off-Schritt dargestellt. Das Indium-Zinn-Oxid bildet hierbei die eigentliche Elektrode des Bildpunktes 20 sowie eine Redundanz der Spaltenleitungen 23 zur gleichzeitigen Reparatur unterbrochener Spalten und stellt eine elektrisch leitfähige Verbindung zwischen dem Drain-Anschluß D des Dünnschichttransistors 19 mit der Deckelektrode 25 des Speicherkondensators 21 dar. In einem weiteren Schritt wird eine Schicht 22 aus Siliziumnitrid, Siliziumoxid oder Siliziumoxinitrid als Passivierung abgeschieden, zum Schutz gegen Umwelteinflüsse.

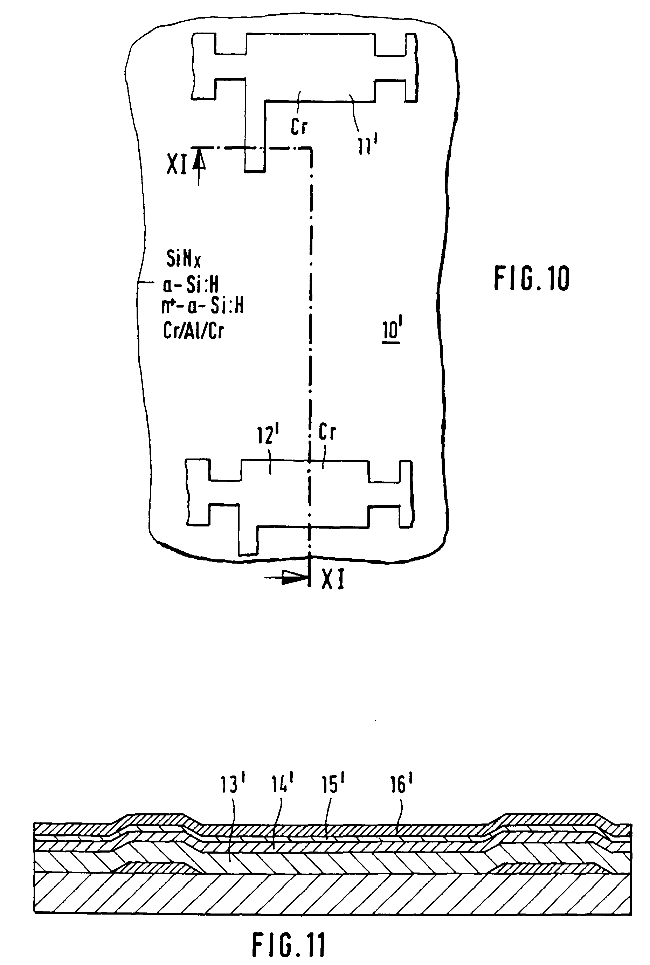

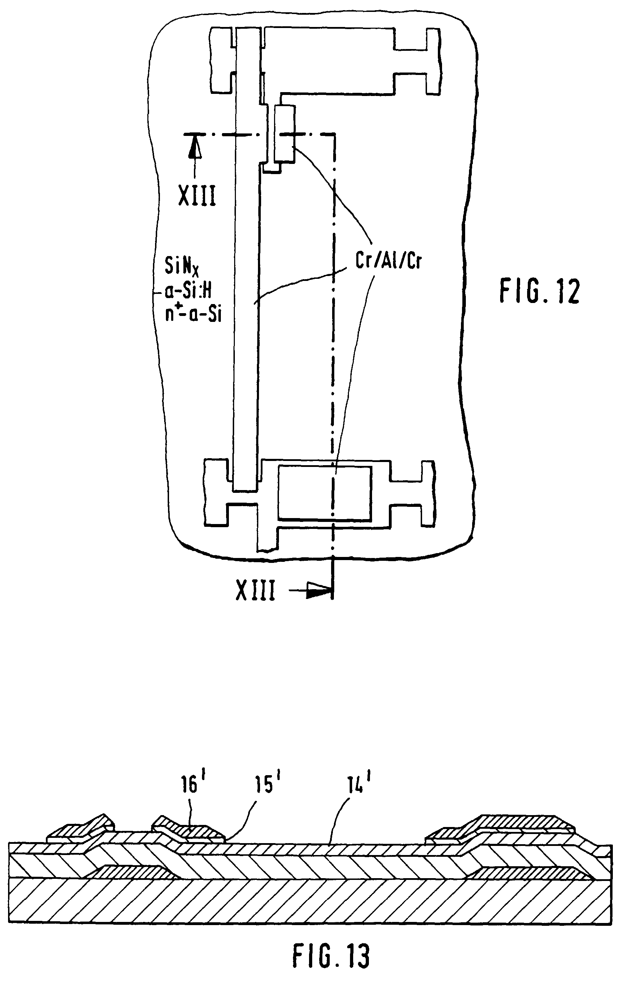

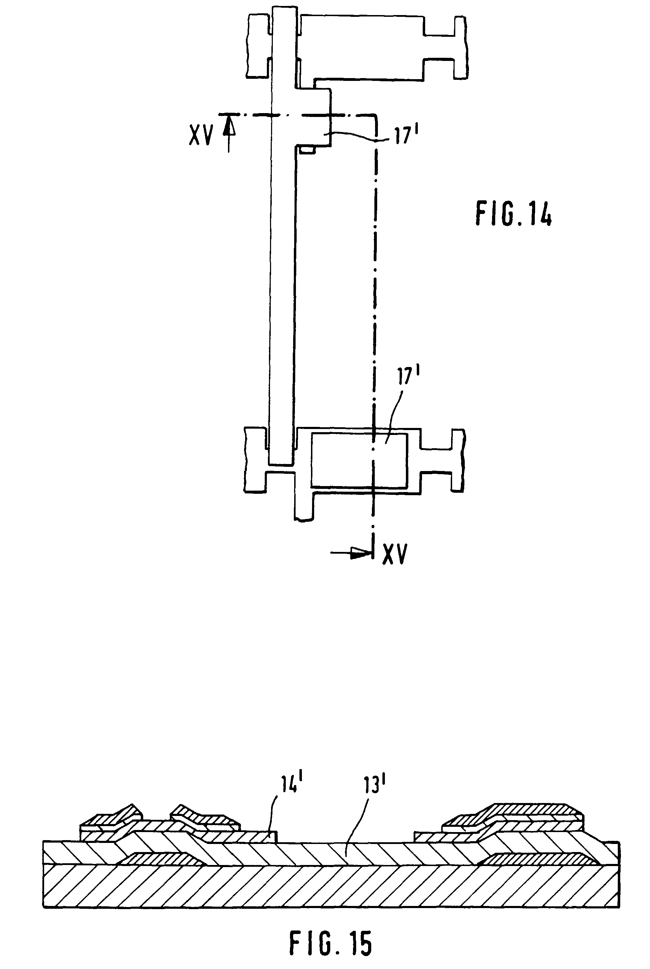

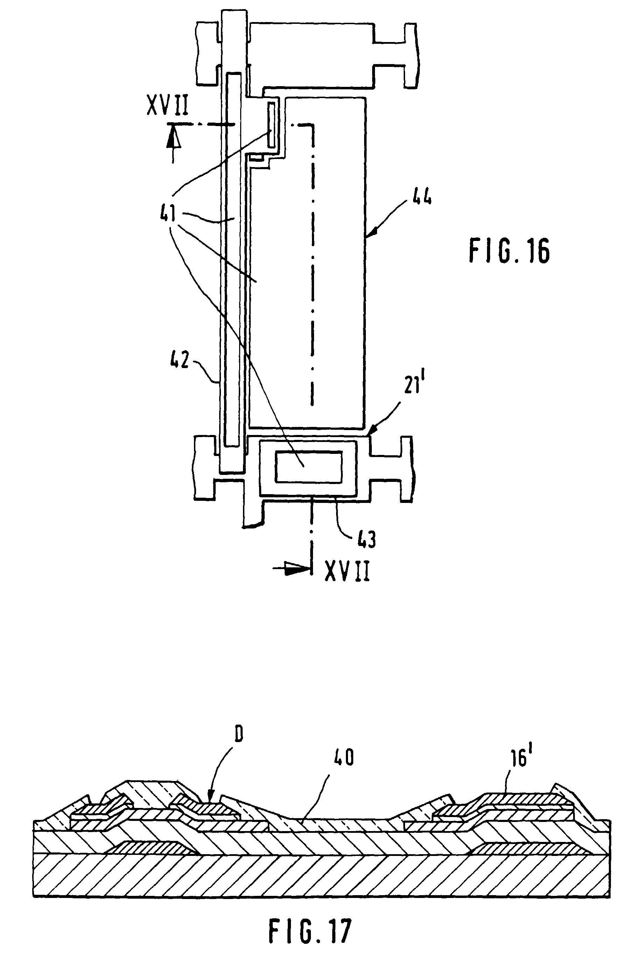

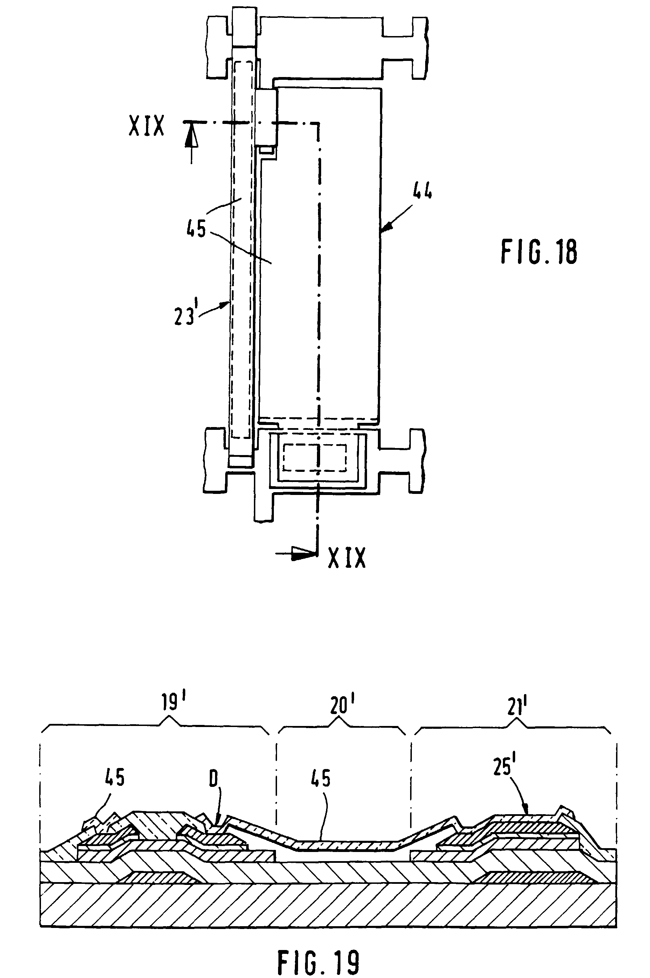

Die Figuren 10 bis 19 zeigen den Herstellungsprozeß eines Bildpunktes eines Flüssigkristallbildschirms nach dem Fünf-Masken-Prozeß. Die in den Figuren 10 bis 15 dargestellten Verfahrensschritte entsprechen den Verfahrensschritten der Figuren 1 bis 6 des Vier-Masken-Prozesses. Für die Beschreibung wird daher auf die Erläuterungen zu den Figuren 1 bis 6 verwiesen. Ab dem in den Figuren 16 und 17 beschriebenen Verfahrensstadium verlaufen der Vier-Masken-Prozeß und der Fünf-Masken-Prozeß jedoch unterschiedlich. Wie in den Figuren 16 und 17 gezeigt ist, werden beim Fünf-Masken-Prozeß nach Strukturieren der undotierten Halbleiterschicht 14' (Fig. 14, 15) ein Isolator 40 wie Siliziumnitrid, Siliziumoxid oder Siliziumoxinitrid mittels eines CVD- oder PECVD-Verfahrens aufgebracht. Anschließend wird der Isolator 40 nach konventionellen photolithographischen Methoden und einem plasma- oder naßchemischen Ätzschritt strukturiert. Hierbei wird der Isolator 40 in den in Fig. 16 eingezeichneten Bereichen 41 sowie der Anschlußstellen der Spalten- und Zeilenleitungen im Außenbereich der Matrix, in Kontaktlöchern 42 auf den Spaltenleitungen 23' und im Bereich des Drain-Anschlusses D und der Deckelektrode 43 des Speicherkondensators 21' entfernt. Außerdem wird der Isolator im Bereich der späteren Bildpunktelektrode 44 weggeätzt, um die Transmission zu erhöhen. In den Figuren 18 und 19 ist der abschließende Schritt des Fünf-Masken-Prozesses, nämlich das Aufsputtern oder Aufdampfen einer transparenten, leitfähigen Schicht 45 wie Indium-Zinn-Oxid und Strukturieren nach konventionellen photolithographischen Methoden mit einem plasma- oder naßchemischen Ätzprozeß dargestellt. Die transparente leitfähige Schicht 45 bildet die eigentliche Bildpunktelektrode 44, eine Redundanz der Spaltenleitungen 23' zur gleichzeitigen Reparatur unterbrochener Spalten und stellt eine elektrisch leitfähige Verbindung zwischen Drain-Anschluß D des Dünnschichttransistors 19' mit der Deckelektrode 43 des Speicherkondensators 21' her. Außerdem bedeckt die zweite leitfähige Schicht 45 die Anschlußstellen der Spaltenleitungen 23' und Zeilenleitungen und gewährleistet somit eine zuverlässige elektrische Verbindung bei der Kontaktierung des Bildschirms mit zugehörigen externen Treibern.

## Patentansprüche

1. Verfahren zur Herstellung einer Matrix aus Dünnschichttransistoren mit Speicherkapazitäten, insbesondere für Flüssigkristallbildschirme, gekennzeichnet durch die Schritte:
A. Aufbringen einer ersten elektrisch leitfähigen Schicht auf ein Substrat (10) und Strukturieren als Zeilen (11) der Dünnschichttransistormatrix, als Gate-Kontakte (G) der Transistoren (19) und als Elektroden (12) der Speicherkapazitäten (21) in einem ersten Maskenschritt,
B. Aufbringen eines Gate-Isolators (13) für die schichttransistoren (19),
C. Aufbringen eines Halbleiters (15), insbesondere von a-Si:H,
D. Aufbringen eines p- oder n-dotierten Halbleiters (15) als Drain- und Source-Kontakte (D, S) der Dünnschichttransistoren (19),
E. Aufbringen und Strukturieren einer zweiten elektrisch leitfähigen Schicht (16) für die Spalten (23) der schichttransistormatrix, für die Drain- und Source-Kontakte (D, S) der Dünnschichttransistoren (19) und die Gegenelektroden (25) der Speicherkapazitäten (21) in einem zweiten Maskenschritt,
F. Plasmaätzen der dotierten Halbleiterschicht (15) mit der zweiten leitfähigen Schicht (16) als Maske, wobei das Ende des Ätzprozesses durch Beobachtung der optischen Emission des Ätzplasmas festgestellt wird,
G. Strukturieren der undotierten Halbleiterschicht (14) in einem dritten Maskenschritt,
H. Aufbringen und Strukturieren einer transparenten leitfähigen Schicht (18) als Bildpunktelektrode (20) und zweite Metallisierung der Spalten (23) sowie zur leitenden Verbindung der Drain-Kontakte (D) der schichttransistoren (19) mit den Gegenelektroden der Speicherkapazitäten (21) in einem vierten Maskenschritt,
I. Aufbringen einer transparenten Passivierung (22).

2. Verfahren zur Herstellung einer Matrix aus Dünnschichttransistoren mit Speicherkapazitäten, insbesondere für Flüssigkristallbildschirme, gekennzeichnet durch die Schritte:
A. Aufbringen einer ersten elektrisch leitfähigen Schicht auf ein Substrat (10') und Strukturieren als Zeilen (11') der Dünnschichttransistormatrix, als Gate-Kontakte (G) der Transistoren (19') und als Elektroden (12') der Speicherkapazitäten (21') in einem ersten Maskenschritt,
B. Aufbringen eines Gate-Isolators (13') für die schichttransistoren (19'),
C. Aufbringen eines Halbleiters (14'), insbesondere von a-Si:H,
D. Aufbringen eines p- oder n-dotierten Halbleiters (15') als Drain- und Source-Kontakte (D, S) der Dünnschichttransistoren (19'),
E. Aufbringen und Strukturieren einer zweiten elektrisch leitfähigen Schicht (16') für die Spalten (23') der Dünnschichttransistormatrix, für die Drain- und Source-Kontakte (D, S) der Dünnschichttransistoren (19') und die Gegenelektroden der Speicherkapazitäten (21') in einem zweiten Maskenschritt,
F. Plasmaätzen der dotierten Halbleiterschicht (15') mit der zweiten leitfähigen Schicht (16') als Maske, wobei das Ende des Ätzprozesses durch Beobachtung der optischen Emission des Ätzplasmas festgestellt wird,
G. Strukturieren der undotierten Halbleiterschicht (14') in einem dritten Maskenschritt,
H. Aufbringen und Strukturieren eines transparenten Isolators (40) in einem vierten Maskenschritt, wobei der Isolator (40) an den Anschlußstellen der Matrix, den Drain-Kontakten (D) der Dünnschichttransistoren (19') und an der Gegenelektrode (25') der Speicherkapazitäten (21') entfernt wird.
I. Aufbringen und Strukturieren einer transparenten leitfähigen Schicht (45) in einem fünften Maskenschritt.

3. Verfahren nach Anspruch 1 oder 2, dadurch gekennzeichnet, daß die Intensität der optischen Emission des Ätzplasmas bei 240,4 nm zur Überwachung des Endes des Ätzens der dotierten Halbleiterschicht (15, 15') gemessen wird.

4. Verfahren nach Anspruch 2 oder 3, dadurch gekennzeichnet, daß der transparente Isolator (40) im vierten Maskenschritt auch im Bereich der Bildpunktelektroden (44) eines Flüssigkristallbildschirms entfernt wird.

5. Verfahren nach einem der Ansprüche 2 bis 4, dadurch gekennzeichnet, daß die transparente leitfähige Schicht (45) dergestalt strukturiert wird, daß eine direkte leitfähige Verbindung zu den Drain-Kontakten (D) der schichttransistoren (19'), den Spalten (23') und der Gegenelektrode (25') der Speicherkapazität (21') entsteht.

6. Verfahren nach einem der Ansprüche 2 bis 5, dadurch gekennzeichnet, daß die transparente leitfähige Schicht (45) die Anschlußstellen der Spalten (23') und Zeilen (11') bedeckt und eine zweite Metallisierung der Spalten (23') darstellt.

7. Verfahren nach einem der Ansprüche 1 bis 6, dadurch gekennzeichnet, daß gemeinsam mit dem undotierten Halbleiter (14, 14') auch der Gate-Isolator (13, 13') strukturiert wird.

8. Verfahren nach einem der Ansprüche 1 bis 7, dadurch gekennzeichnet, daß die erste leitfähige Schicht aus Chrom, Aluminium, Molybdän, Tantal oder Kombinationen dieser Metalle besteht.

9. Verfahren nach einem der Ansprüche 1 bis 8, dadurch gekennzeichnet, daß nacheinander 400 nm SiNₓ als Gate-Isolator (13, 13'), 130 nm a-Si:H als Halbleiter (14, 14') und 50 nm n⁺-a-Si:H als Drain- und Source-Kontakte (D, S) auf das Substrat (10, 10') mit 200 nm Chrom-Schicht für die Zeilen (11, 11') der Matrix, die Gate-Kontakte (G) der Transistoren (19, 19') und für die Grundelektroden (12, 12') der Speicherkapazitäten (21, 21') abgeschieden werden.

10. Verfahren nach einem der Ansprüche 1 bis 9, dadurch gekennzeichnet, daß die Abscheidung des Gate-Isolators (13, 13'), des Halbleiters (14, 14') und des dotierten Halbleiters (15, 15') für die Drain- und Source-Kontakte (D, S) ohne Unterbrechung des Vakuums in einem PECVD-System erfolgt.

11. Verfahren nach einem der Ansprüche 1 bis 10, dadurch gekennzeichnet, daß die Isolatorschicht (13, 13') an den Überkreuzungsstellen der Zeilen (11, 11')und Spalten (23, 23') bei allen Ätzschritten durch die zweite leitfähige Schicht (16, 16') geschützt ist.

## Claims

1. A process for producing a matrix of thin film transistors with storage capacitors, particularly for liquid crystal displays, characterised by the steps:
A. depositing a first electrically conductive layer on a substrate (10) and structuring as lines (11) of the thin film transistor matrix, as gate contacts (G) of the transistors (19) and as electrodes (12) of the storage capacitors (21) in a first masking step,
B. depositing a gate insulator (13) for the thin film transistors (19),
C. depositing a semiconductor (15), of a-Si:H in particular,
D. depositing a p- or n-doped semiconductor (15) as the drain and source contacts (D, S) of the thin film transistors (19),
E. depositing and structuring a second electrically conductive layer (16) for the columns (23) of the thin film transistor matrix, for the drain and source contacts (D, S) of the thin film transistors (19) and for the backplate electrodes (25) of the storage capacitors (21) in a second masking step,
F. plasma-etching the doped semiconductor layer (15) using the second conductive layer (16) as a mask, wherein the end of the etching process is ascertained by observing the optical emission of the etching plasma,
G. structuring the undoped semiconductor layer (14) in a third masking step,
H. depositing and structuring a transparent conductive layer (18) as an image spot electrode (20), and a second metallising of the columns (23) and for the conductive connection of the drain contacts (D) of the thin film transistors (19) to the backplate electrodes of the storage capacitors (21) in a fourth masking step,
I. depositing a transparent passivation layer (22).

2. A process for producing a matrix of thin film transistors with storage capacitors, particularly for liquid crystal displays, characterised by the steps:
A. depositing a first electrically conductive layer on a substrate (10') and structuring as lines (11') of the thin film transistor matrix, as gate contacts (G) of the transistors (19') and as electrodes (12') of the storage capacitors (21') in a first masking step,
B. depositing a gate insulator (13') for the thin film transistors (19'),
C. depositing a semiconductor (14'), of a-Si:H in particular,
D. depositing a p- or n-doped semiconductor (15') as drain and source contacts (D, S) of the thin film transistors (19'),
E. depositing and structuring a second electrically conductive layer (16') for the columns (23') of the thin film transistor matrix, for the drain and source contacts (D, S) of the thin film transistors (19') and for the backplate electrodes of the storage capacitors (21') in a second masking step,
F. plasma-etching the doped semiconductor layer (15') using the second conductive layer (16') as a mask, wherein the end of the etching process is ascertained by observing the optical emission of the etching plasma,
G. structuring the undoped semiconductor layer (14') in a third masking step,
H. depositing and structuring a transparent insulator (40) in a fourth masking step, wherein the insulator (40) is removed at the connecting points of the matrix, at the drain contacts (D) of the thin film transistors (19') and at the backplate electrode (25') of the storage capacitors (21'),
I. depositing and structuring a transparent conductive layer (45) in a fifth masking step.

3. A process according to claim 1 or 2, characterised in that the intensity of the optical emission of the etching plasma at 240.4 nm is measured for monitoring the end of the etching of the doped semiconductor layer (15, 15').

4. A process according to claim 2 or 3, characterised in that in the fourth masking step the transparent insulator (40) is also removed in the region of the image spot electrodes (44) of a liquid crystal display.

5. A process according to any one of claims 2 to 4, characterised in that the transparent conductive layer (45) is structured in such a way that a direct conductive connection is produced to the drain contacts (D) of the thin film transistors (19'), to the columns (23'), and to the backplate electrode (25') of the storage capacitor (21').

6. A process according to any one of claims 2 to 5, characterised in that the transparent conductive layer (45) covers the connecting points of the columns (23') and lines (11') and constitutes a second metallisation of the columns (23').

7. A process according to any one of claims 1 to 6, characterised in that the gate insulator (13, 13') is also structured together with the undoped semiconductor (14, 14').

8. A process according to any one of claims 1 to 7, characterised in that the first conductive layer consists of chromium, aluminium, molybdenum, tantalum or combinations of these metals.

9. A process according to any one of claims 1 to 8, characterised in that 400 nm SiNₓ as the gate insulator (13, 13'), 130 nm a-Si:H as the semiconductor (14, 14') and 50 nm n⁺-a-Si:H as the drain and source contacts (D, S) are deposited in succession on the substrate (10, 10') with a 200 nm chromium layer for the lines (11, 11') of the matrix, for the gate contacts (G) of the transistors (19, 19') and for the base electrodes (12, 12') of the storage capacitors (21, 21').

10. A process according to any one of claims 1 to 9, characterised in that deposition of the gate insulator (13, 13'), of the semiconductor (14, 14') and of the doped semiconductor (15, 15') for the drain and source contacts (D, S) is effected without interrupting the vacuum in a PECVD system.

11. A process according to any one of claims 1 to 10, characterised in that in all the etching steps the insulator layer (13, 13') is protected by the second conductive layer (16, 16') at the crossover points of the lines (11, 11') and the columns (23, 23').

## Revendications

1. Procédé pour la fabrication d'une matrice de transistors à couche mince à capacités de mémoire, en particulier pour écrans à cristaux liquides, caractérisé par les étapes de :
A. dépôt d'une première couche conductrice électriquement sur un substrat (10) et structuration comme lignes (11) de la matrice de transistors à couche mince, comme contacts de grille (G) des transistors (19) et comme électrodes (12) des capacités de mémoire (21) dans une première étape de masquage,
B. dépôt d'un isolant de grille (13) pour les transistors à couche mince (19),
C. dépôt d'un semi-conducteur (15), en particulier de a-Si:H,
D. dépôt d'un semi-conducteur dopé p ou n (15) comme contacts de drain et de source (D, S) des transistors à couche mince (19),
E. dépôt et structuration d'une deuxième couche conductrice électriquement (16) pour les colonnes (23) de la matrice de transistors à couche mince, pour les contacts de drain et de source (D, S) des transistors à couche mince (19) et les contre-électrodes (25) des capacités de mémoire (21) dans une deuxième étape de masquage,
F. gravure par plasma de la couche de semi-conducteur dopée (15) avec la deuxième couche conductrice (16) comme masque, la fin du processus de gravure étant constatée par observation de l'émission optique du plasma de gravure,
G. structuration de la couche de semi-conducteur non dopée (14) dans une troisième étape de masquage,
H. dépôt et structuration d'une couche conductrice transparente (18) comme électrode de pixel (20) et deuxième métallisation des colonnes (23) ainsi que pour liaison conductrice des contacts de drain (D) des transistors à couche mince (19) avec les contre-électrodes des capacités de mémoire (21) dans une quatrième étape de masquage,
I. dépôt d'une passivation transparente (22).

2. Procédé pour la fabrication d'une matrice de transistors à couche mince avec capacités de mémoire, en particulier pour écrans à cristaux liquides, caractérisé par les étapes de :
A. dépôt d'une première couche conductrice électriquement sur un substrat (10') et structuration comme lignes (11') de la matrice de transistors à couche mince, comme contacts de grille (G) des transistors (19') et comme électrodes (12') des capacités de mémoire (21') dans une première étape de masquage,
B. dépôt d'un isolant de grille (13') pour les transistors à couche mince (19'),
C. dépôt d'un semi-conducteur (14'), en particulier de a-Si:H,
D. dépôt d'un semi-conducteur dopé p ou n (15') comme contacts de drain et de source (D, S) des transistors à couche mince (19'),
E. dépôt et structuration d'une deuxième couche conductrice électriquement (16') pour les colonnes (23') de la matrice de transistors à couche mince, pour les contacts de drain et de source (D, S) des transistors à couche mince (19') et les contre-électrodes des capacités de mémoire (21') dans une deuxième étape de masquage,
F. gravure par plasma de la couche de semi-conducteur dopée (15') avec la deuxième couche conductrice (16') comme masque, la fin du processus de gravure étant constatée par observation de l'émission optique du plasma de gravure,
G. structuration de la couche de semi-conducteur non dopée (14') dans une troisième étape de masquage,
H. dépôt et structuration d'un isolant transparent (40) dans une quatrième étape de masquage, l'isolant (40) étant retiré sur les points de connexion de la matrice, les contacts de drain (D) des transistors à couche mince (19') et sur la contre-électrode (25') des capacités de mémoire (21'),
I. dépôt et structuration d'une couche conductrice transparente (45) dans une cinquième étape de masquage.

3. Procédé selon la revendication 1 ou 2, caractérisé en ce que l'intensité de l'émission optique du plasma de gravure à 240,4 nm pour la surveillance de la fin de la gravure de la couche de semi-conducteur dopée (15, 15') est mesurée.

4. Procédé selon la revendication 2 ou 3, caractérisé en ce que dans la quatrième étape de masquage l'isolant transparent (40) est retiré aussi dans la zone des électrodes de pixel (44) d'un écran à cristaux liquides.

5. Procédé selon l'une des revendications 2 à 4, caractérisé en ce que la couche conductrice transparente (45) est structurée de telle sorte qu'une liaison conductrice directe est établie avec les contacts de drain (D) des transistors à couche mince (19'), les colonnes (23') et la contre-électrode (25') de la capacité de mémoire (21').

6. Procédé selon l'une des revendications 2 à 5, caractérisé en ce que la couche conductrice transparente (45) recouvre les points de connexion des colonnes (23') et des lignes (11') et constitue une deuxième métallisation des colonnes (23').

7. Procédé selon l'une des revendications 1 à 6, caractérisé en ce que l'isolant de grille (13, 13') aussi est structuré ensemble avec le semi-conducteur non dopé (14, 14').

8. Procédé selon l'une des revendications 1 à 7, caractérisé en ce que la première couche conductrice est constituée de chrome, d'aluminium, de molybdène, de tantale ou de combinaisons de ces métaux.

9. Procédé selon l'une des revendications 1 à 8, caractérisé en ce que 400 nm de SiNₓ comme isolant de grille (13, 13'), 130 nm de a-Si:H comme semi-conducteur (14, 14') et 50 nm de n⁺-a-Si:H comme contacts de drain et de source (D, S) sont déposés les uns après les autres sur le substrat (10, 10') avec 200 nm de couche de chrome pour les lignes (11, 11') de la matrice, les contacts de grille (G) des transistors (19, 19') et pour les électrodes de base (12, 12') des capacités de mémoire (21, 21').

10. Procédé selon l'une des revendications 1 à 9, caractérisé en ce que le dépôt de l'isolant de grille (13, 13'), du semi-conducteur (14, 14') et du semi-conducteur dopé (15, 15') pour les contacts de drain et de source (D, S) s'effectue sans interruption du vide dans un système PECVD.

11. Procédé selon l'une des revendications 1 à 10, caractérisé en ce que la couche d'isolant (13, 13') sur les points de croisement des lignes (11, 11') et des colonnes (23, 23') est protégée par la deuxième couche conductrice (16, 16') pendant toutes les étapes de gravure.
